Europäisches Patentamt

European Patent Office

Office européen des brevets

(11) Publication number: **0 173 570**
**A2**

# EUROPEAN PATENT APPLICATION

(21) Application number: **85306128.1**

(22) Date of filing: **29.08.85**

(51) Int. Cl.⁴: **G 11 C 19/00, G 11 C 19/28**

(30) Priority: **31.08.84 JP 180632/84**

(43) Date of publication of application: **05.03.86**
**Bulletin 86/10**

(84) Designated Contracting States: **DE FR GB**

(71) Applicant: **FUJITSU LIMITED, 1015, Kamikodanaka Nakahara-ku, Kawasaki-shi Kanagawa 211 (JP)**

(72) Inventor: **Ohba, Osam, 5-11-19, Kamiyoga Setagaya-ku, Tokyo 158 (JP)**
Inventor: **Yoshida, Makoto, Dai-2 Seizan-so 6 764, Shimokodanaka Nakahara-ku, Kawasaki-shi Kanagawa 211 (JP)**

(74) Representative: **Rackham, Stephen Neil et al, GILL JENNINGS & EVERY 53-64 Chancery Lane, London WC2A 1HN (GB)**

(54) **Shift register circuit.**

(57) An elementary shift register circuit (1, 2, 3) for holding one data bit and for connection in sequence to form a shift register circuit consists of four logic gates (21, 22, 23, 24) such as NAND or NOR gates connected in sequence. Each gate (22) has a first input terminal for receiving a signal from the succeeding gate (23), a second input terminal for receiving a signal from the preceding gate (21), and a third input terminal for receiving a predetermined control signal (CONT 1-4). The outputs of the second (22) and third (23) gates are the data outputs of the elementary circuit of the shift register.

## Shift Register Circuit

The present invention relates to a shift register circuit used for data processing apparatus.

Previously, for example, a four-bit bi-directional shift register is constructed by connecting together four elementary circuits for storing 1 bit of data each.  For example, an elementary circuit for such a shift register consists of five three-input NAND gates, one four-input NAND gate, two two-input AND gates and one two-input NOR gate.  The whole shift register includes only one NOT gate for common use.

In such a prior art elementary circuit for a shift register, eight gates, in terms of NAND gates, are used per bit, and, in addition the common element.  In the above elementary circuit for a shift register, in the normal state, 2 to 4 gates per bit are in the ON state to deliver a LOW potential output.  This shows that 2 to 4 gates per bit are in the current-passing state and this requires a large power consumption.

In such an elementary circuit for a shift register, it is necessary to provide five control lines for transmitting a $\overline{\text{SET}}$ (barred SET) signal, a $\overline{\text{RESET}}$ (barred RESET) signal, a RIGHT-SHIFT signal, a LEFT-SHIFT signal, and a CLOCK signal for each elementary circuit, where each of the $\overline{\text{SET}}$ and $\overline{\text{RESET}}$ signals are significant when the potential of the signal is LOW.

The prior art shift register has a disadvantage in that a large number of logic gates are used, and that this large number of logic gates is made ON, thus requiring a large power consumption where transistor-transistor-logic (TTL) circuits are used for the logic gates, and that a large number of control lines must be used.

According to a first aspect of this invention an elementary circuit for holding one data bit in a shift register circuit comprises four gates connected in sequence, each of the gates having a first input terminal for receiving an output signal of the succeeding gate, a second input terminal for receiving an output signal of the preceding gate, and a third input terminal for receiving predetermined control signals, the outputs of second and third gates forming outputs of the elementary circuit for one bit of the shift register, and, a first, a second, a third, and a fourth control signal being applied to the third input terminals respectively of the first to fourth gates.

According to a second aspect of this invention a shift register circuit comprises a plurality of elementary shift register circuits connected in sequence, each of the elementary shift register circuits comprises a first, a second, a third, and a fourth logic gate, the output of the second logic gate being connected to a first input terminal of the first logic gate, a right-shifted signal from a preceding elementary shift register circuit being supplied to the second input terminal of the first logic gate, the output of the third logic gate being connected to a first input terminal of the second logic gate, the output of the first logic gate being connected to a second input terminal of the second logic gate, the output of the fourth logic gate being connected to a first input terminal of the third logic gate, the output of the second logic gate being connected to a second input terminal of the third logic gate, a left-shifted signal from a succeeding elementary shift register circuit being supplied to a first input terminal of the fourth logic gate, the output of the third logic gate being connected to the second input terminal of the fourth logic gate, digital signals having predetermined polarity, predetermined duration, and predetermined timing with respect to a sequential order being supplied to the third input terminals of each of the first to fourth logic gates, the output of the first logic gate being supplied to the preceding elementary shift register circuit as a left-shifted signal, the output of the fourth logic gate being supplied to the succeeding elementary shift register circuit as a right-shifted signal, and the output of the second logic gate forming a positive output and the output of the third logic gate forming a negative output of the elementary shift register circuit.

The present invention provides an improved shift register in which the number of constituent logic gates per bit is smaller, and accordingly, the power consumption is smaller, and further, there are less control lines.

Particular examples of shift register in circuits in accordance with this invention will now be described and contrasted with the prior art with reference to the accompanying drawings, in which:-

Figure 1 is a circuit diagram of a prior elementary shift register circuit;

Figure 2 is a circuit diagram of an elementary shift register circuit for a shift register circuit according to an example of the present invention;

Figure 3 is a circuit diagram of a shift register circuit using the elementary shift register circuit shown in Figure 2;

Figure 4 is a chart showing the sequence of changes of the potentials of the control signals used in the circuit shown in Figure 3;

Figures 5 to 8 are graphs illustrating the changes with time of the potentials of the signals in the circuit shown in Figure 2;

Figure 9 is a circuit diagram of an example of the control clock generation circuit;

Figures 10 to 13 are graphs illustrating waveforms of the signals in the circuit shown in Figure 9;

Figure 14 shows an elementary shift register circuit for a shift register circuit according to another example of the present invention;

Figures 15 to 19 are circuit diagrams of the concrete structure of the elementary shift register circuit shown in Figure 2; and,

Figures 20 to 23 are circuit diagrams of the concrete structure of the elementary shift register circuit shown in Figure 14.

Before starting the description of the embodiments of the present invention, a prior art elementary shift register circuit will be described with reference to Figure I. A 4-bit bidirectional shift register is constituted by four elementary shift register circuits 8 for storing 1-bit data.

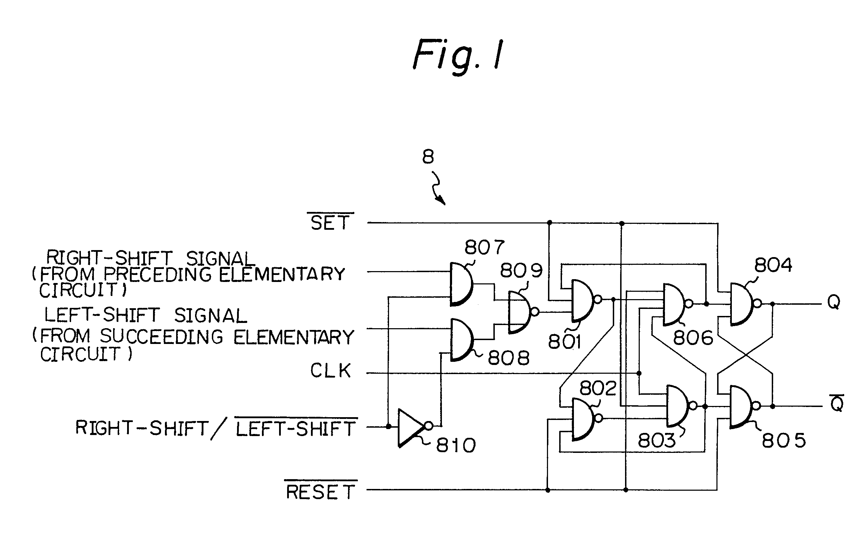

The elementary shift register circuit 8 consists of five 3-input NAND gates 801, 802, 803, 804, and 805, one 4-input NAND gate 806, two 2-input AND gates 807 and 808, and one 2-input NOR gate 809. Only one NOT gate 810 in common is sufficient for the shift register. As shown in Figure 1, eight gates, in terms of NAND gates, are used per bit except for the common element.

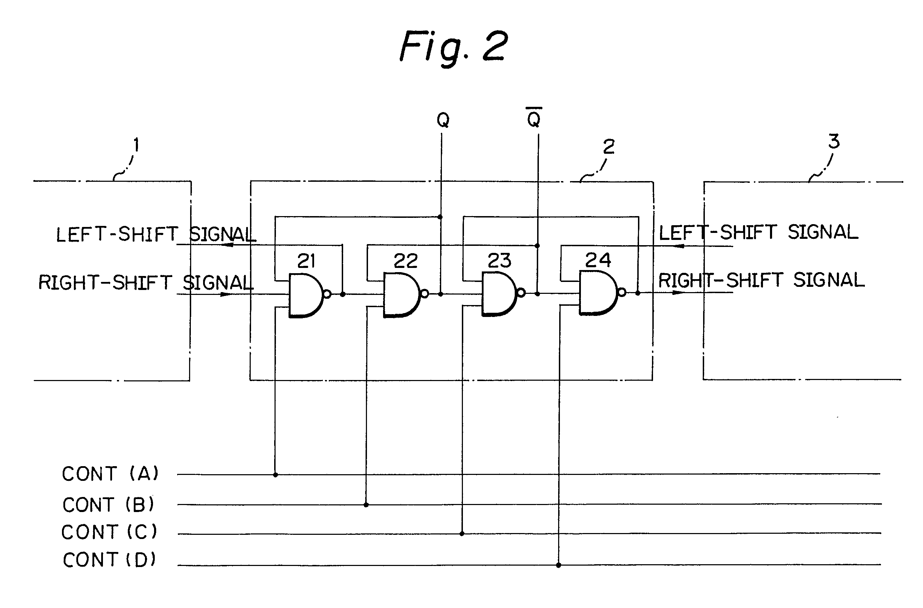

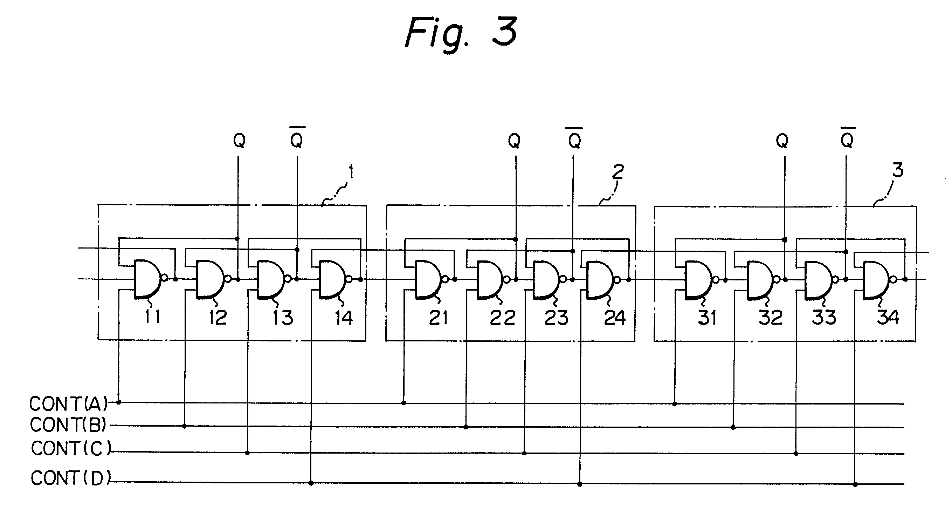

An elementary shift register circuit for a shift register circuit according to an embodiment of the present invention is shown in Figure 2. The shift register circuit using the elementary shift register circuit shown in Figure 2 is shown in Figure 3.

In Figure 2, the elementary shift register circuit 2 consists of four 3-input NAND gates 21, 22, 23, and 24. The preceding elementary shift register circuit 1 is provided to the left of the elementary shift register circuit 2. The succeeding elementary shift register circuit 3 is provided to the right of the elementary shift register circuit 2. A right-shift signal from the preceding elementary shift register circuit 1 is supplied to the second input terminal of the NAND gate 21. The output of the NAND gate 22 is supplied to the first input of the NAND gate 21. A control clock signal CONT(A) from the control clock signal circuit is supplied to the third input terminal of the NAND gate 21.

The output of the NAND gate 21 is supplied to the second input terminal of the NAND gate 22. The output of the NAND gate 23 is supplied to the first input terminal of the NAND gate 22. A control clock signal CONT(B) from the control clock signal circuit is supplied to the third input terminal of the NAND gate 22.

The output of the NAND gate 22 is supplied to the second input terminal of the NAND gate 23. The output of the NAND gate 24 is supplied to the first input terminal of the NAND gate 23. A control clock signal CONT(C) from the control clock signal circuit is supplied to the third input terminal of the NAND gate 23.

The output of the NAND gate 23 is supplied to the second input terminal of the NAND gate 24. A left-shift signal from the succeeding elementary shift register circuit 3 is supplied to the first input terminal of the NAND gate 24. A control clock signal CONT(D) from the control clock signal circuit is supplied to the third input terminal of the NAND gate 24.

The positive output Q of the elementary shift register circuit 2 is delivered from the output terminal of the NAND gate 22. The negative output $\bar{Q}$ (barred Q) of the elementary shift register circuit 2 is delivered from the output terminal of the NAND gate 23.

The control clock signals CONT(A), CONT(B), CONT(C), and CONT(D) from the control clock signal circuit are supplied to each third input terminal of the NAND gates 21, 22, 23, and 24.

The basic operation of the elementary shift register circuit shown in Fig. 2 will be described below.

In the stable state, the potentials of the control clock signals CONT(A), CONT(B), CONT(C), and CONT(D) are LOW, HIGH, HIGH, and LOW, respectively. Therefore, the potentials of the outputs of the NAND gates 21 and 24 are HIGH so that only the NAND gates 22 and 23 are active to form a latch circuit. Since the output of the gate 22 is supplied to an input terminal of the gate 23 and the output of the gate 23 is supplied to an input terminal of the gate 22, the two NAND gates 22 and 23 form a latch circuit which holds $Q$ and $\bar{Q}$ signals at the output terminals of the gates 22 and 23.

The gate 21 is the left-hand side gate, and the gate 24 is the right-hand side gate.

In the basic right shift operation, the output signals $Q$, $\bar{Q}$ of the gates 22 and 23 are shifted to the output signals $Q$, $\bar{Q}$ of the gates 23 and 24.

First, the potentials of the control clock signals CONT(A), CONT(B), CONT(C), and CONT(D) become LOW, HIGH, HIGH, and HIGH. Since the potential of the control clock signal CONT(A) is LOW, the potential of the first input of the gate 24 is HIGH. Hence, the output signal $\bar{Q}$ of the gate 23 is inverted by the gate 24 to produce the output signal $Q$ as the output of the gate 24.

Second, the potentials of the control signals CONT(A), CONT(B), CONT(C), and CONT(D) become LOW, LOW, HIGH, and HIGH. The potential of the output of the gate 22 becomes HIGH so that the gates 23 and 24 form a latch circuit which holds the signals $Q$, $\bar{Q}$ at the output terminals of the gates 23 and 24. In this condition, it seems that the stable state is shifted in one gate.

The basic left-shift operation can be explained in a manner similar to the above described basic right shift operation.

The operation of the elementary shift register circuits 1, 2, and 3 shown in Fig. 3 will be described below in the case of a right-shift operation, focusing on the signals Q and $\bar{Q}$ in the elementary shift register circuit 2, which are shifted to the elementary shift register circuit 3.

(1) First, the potentials of the control clock signals CONT(A), CONT(B), CONT(C) and CONT(D) are LOW, HIGH, HIGH, and LOW, and the elementary shift register circuits 1, 2, and 3 are in the stable state.

To the first input terminal of the NAND gate 24, the HIGH potential of the left-shift signal is applied. To the second input terminal of the NAND gate 24, the signal $\bar{Q}$ is applied.

(2) When the potential of the control signal CONT(D) becomes HIGH, the right-shift signal from the NAND gate 24 represents the inverted signal of the signal $\bar{Q}$; i.e., Q.

(3) When the potential of the control signal CONT(B) becomes LOW, the potential of the output Q of the NAND gates 22 and 32 becomes HIGH.

(4) When the potential of the control signal CONT(A) becomes HIGH, the output of the NAND gate 31 represents the inverted signal of the right-shift signal applied to the second input terminal of the NAND gate 31, since the potential of the signal Q applied to the first gate of the NAND gate 31 is HIGH.

Since the potential of the signal Q in the elementary shift register circuit 2 is transmitted to the second input terminal of the NAND gate 31, the left-shift signal delivered from the output terminal of the NAND gate 31 represents the inverted signal of the Q signal in the elementary shift register circuit 2, that is, the signal $\bar{Q}$ in the preceding elementary shift register circuit 2.

(5) When the potential of the control signal CONT(C) becomes LOW, the potential of the output signal $\bar{Q}$ of the NAND gate 33 becomes HIGH.

(6)    When the potential of the control signal
CONT(B) is restored to HIGH, the output signal of the
NAND gate 32 represents the inverted signal of the
output signal $\bar{Q}$ of the NAND gate 31, that is, the
signal Q.

(7)    When the potential of the control signal
CONT(D) is restored to LOW, the potential of the right-
shift signal delivered from the NAND gate 24 becomes
HIGH.

(8)    When the potential of the control signal
CONT(C) is restored to HIGH, the output of the NAND
gate 23 represents the inverted signal of the output
signal Q of the NAND gate 32, that is, the signal $\bar{Q}$.

(9)    When the potential of the control signal
CONT(A) is restored to LOW, the potential of the left-
shift signal delivered from the output terminal of the
NAND gate 31 becomes HIGH.  This state is again the
stable state.

A process of the right-shift operation is thus
carried out through the above-indicated steps (1)
to (9).  By this right-shift operation, the output
signals Q and $\bar{Q}$ of the preceding elementary shift
register circuit 2 is transferred to the output signals Q
and $\bar{Q}$ of the present elementary shift register circuit 3.
The potentials of the other signals and the outputs of
the logic gates are restored to the state prevailing
before this right-shift operation.

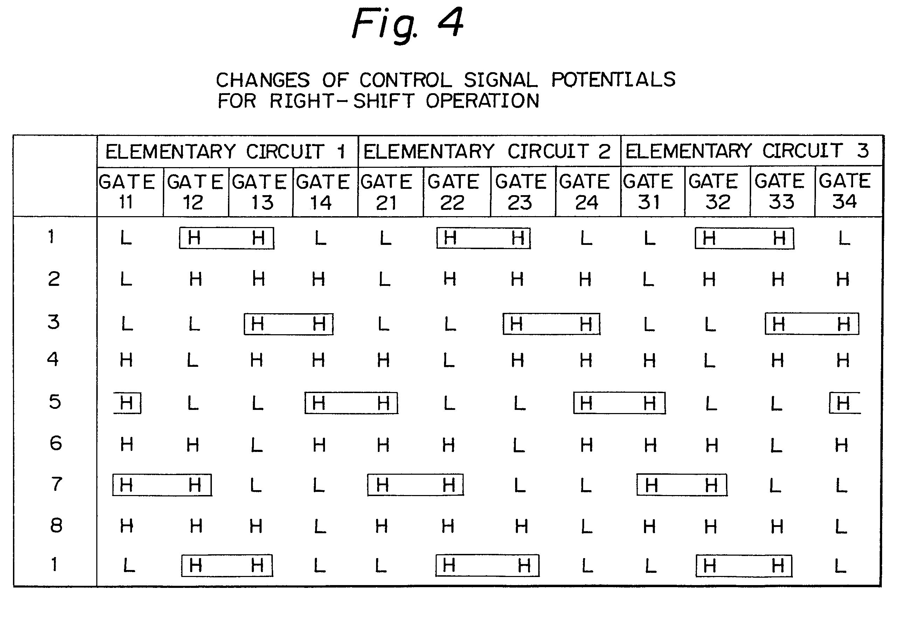

The sequence of changes of the potentials of the
control signals CONT(A), CONT(B), CONT(C), and CONT(D)
are illustrated in Fig. 4.

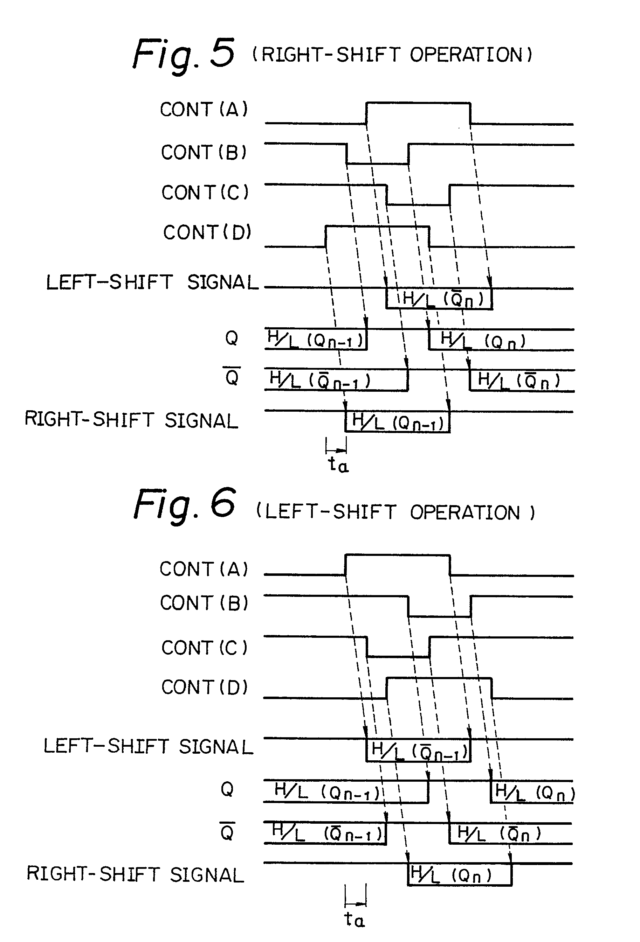

The changes with time of the potentials of the
signals in the elementary shift register circuit 3 shown
in Fig. 2, in the above-described right-shift operation,
are illustrated in Fig. 5.  Figure 5 shows the waveforms
of the control signals CONT(A), CONT(B), CONT(C),
and CONT(D), the left-shift signal, the signal Q, the
signal $\bar{Q}$, and the right-shift signal.  In Fig. 5, $t_a$

is the time length necessary for the operation of each of the logic gates, and the indication H/L represents the possibility of either a HIGH potential or LOW potential.

The operation of the elementary shift register circuit 1, 2, and 3 shown in Fig. 3 will now be described in the case of a left-shift operation, focusing on the signal Q, $\bar{Q}$ in the elementary shift register circuit 2 which are transmitted to the shift register circuit 1.

In the left-shift operation, the control clock signals CONT(A), CONT(B), CONT(C), and CONT(D) are changed according to the sequence from No. 8 to No. 1 of Fig. 4, because of the symmetrical structure of the circuit.

(1) First, in the stable state, the potentials of the control clock signals CONT(A), CONT(B), CONT(C), and CONT(D) are LOW, HIGH, HIGH, and LOW. To the second input terminal of the NAND gates 11 and 21, the HIGH potential of the right-shift signal is applied.

(2) When the potential of the control signal CONT(A) becomes HIGH, the left-shift signal from the NAND gate 21 represents the inverted signal of the output signal Q of the gate 22; i.e., $\bar{Q}$.

(3) When the potential of the control signal CONT(C) becomes LOW, the potential of the output $\bar{Q}$ of the NAND gate 13 becomes HIGH.

(4) When the potential of the control signal CONT(D) becomes HIGH, the output terminal of the NAND gate 14 represents the inverted signal of the left-shift signal from the output terminal of the gate 21 in the elementary shift register circuit 2, i.e., Q, since the potential of the output signal $\bar{Q}$ of the gate 13 is HIGH.

(5) When the potential of the control signal CONT(B) becomes LOW, the potential of the output Q of the NAND gate 12 becomes HIGH.

(6) When the potential of the control signal CONT(C) becomes HIGH, the signal $\bar{Q}$ delivered from the output terminal of the NAND gate 23 represents the inverted signal of the right-shift signal from the NAND gate 14, i.e., $\bar{Q}$, since the potential of the second input signal Q of the gate 12 is HIGH.

(7)   When the potential of the control signal CONT(A) becomes LOW, the potential of the output terminal of the NAND gate 11 becomes HIGH.

(8)   When the potential of the control signal CONT(B) becomes HIGH, the signal Q delivered from the NAND gate 12 represents the inverted signal of the output signal $\bar{Q}$ of the gate 13, i.e., Q, since the potential of the output terminal of the NAND gate 11 is HIGH.

(9)   When the potential of the control signal CONT(D) becomes LOW, the potential of the right-shift signal delivered from the NAND gate 14 becomes HIGH. This state is again the stable state.

The process of the left-shift operation is carried out through the above-indicated steps (1) to (9).   By this left-shift operation, the output signals Q and $\bar{Q}$ of the elementary shift register circuit 2 are transferred to the output signals Q and $\bar{Q}$ of the elementary shift register circuit 1.   The potentials of the other signals and the outputs of the logic gates are restored to the state prevailing before this left-shift operation.

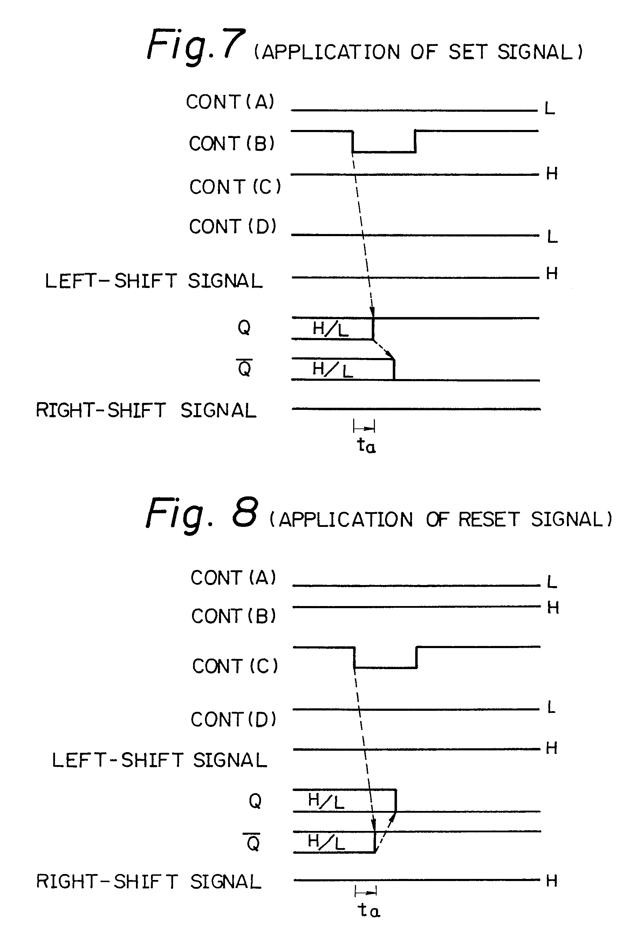

The changes with time of the potentials of the signals in the elementary shift register circuit 1 shown in Fig. 2, in the above-described left-shift operation, are illustrated in Fig. 6, in the manner similar to Fig. 5. –

The operation of the elementary shift register circuit 2 shown in Fig. 2 will now be described in the case of the setting operation.   By the setting operation the potential of the signal Q is made HIGH, and the potential of the signal $\bar{Q}$ is made LOW.

(1)   In the stable state, the potentials of the control clock signals CONT(A), CONT(B), CONT(C), and CONT(D) are LOW, HIGH, HIGH, and LOW. When the potential of the control signal CONT(B) becomes LOW, the potential of the signal Q delivered from the NAND gate 22 becomes HIGH.

(2) In the stable state, the potential of the right-shift signal supplied to the first input terminal of the NAND gate 23 is HIGH, and the potential of the control signal CONT(C) supplied to the third input terminal of the NAND gate 23 is HIGH.

According to the operation indicated in (1), above, the potential of the signal Q supplied to the second input terminal of the NAND gate 23 becomes HIGH so that the potential of the signal $\bar{Q}$ delivered from the NAND gate becomes LOW.

(3) The potential of the control signal CONT(B) is restored to HIGH so that the shift register returns to the stable state.

The process of the setting operation is carried out through the above-indicated steps (1) to (3). The changes with time of the potentials of the signals in the elementary shift register circuit 2 shown in Fig. 2, in the above-described setting operation, are illustrated in Fig. 7.

The operation of the elementary shift register circuit 2 shown in Fig. 2 will now be described in the case of the resetting operation. By the resetting operation the potential of the signal Q is made LOW, and the potential of the signal $\bar{Q}$ is made HIGH.

(1) In the stable state, the potentials of the control clock signals CONT(A), CONT(B), CONT(C), and CONT(D) are LOW, HIGH, HIGH, and LOW. When the potential of the control signal CONT(C) becomes LOW, the signal $\bar{Q}$ delivered from the NAND gate 23 becomes HIGH.

(2) In the stable state, the potential of the left-shift signal supplied to the second input terminal of the NAND gate 22 is HIGH, and the potential of the

- 12 -       0173570

control signal CONT(B) supplied to the third input terminal of the NAND gate 22 is HIGH.

According to the operation indicated in (1), above, the potential of the signal $\bar{Q}$ becomes HIGH so that the potential of the signal Q delivered from the NAND gate becomes LOW.

(3)  The potential of the control signal CONT(C) is restored to HIGH, so that the shift register returns to the stable state.

By these steps (1) to (3), the resetting operation is carried out.  The changes with time of the potentials of the signals in the elementary shift register circuit 2 shown in Fig. 2, in the above-described resetting operation, are illustrated in Fig. 8.

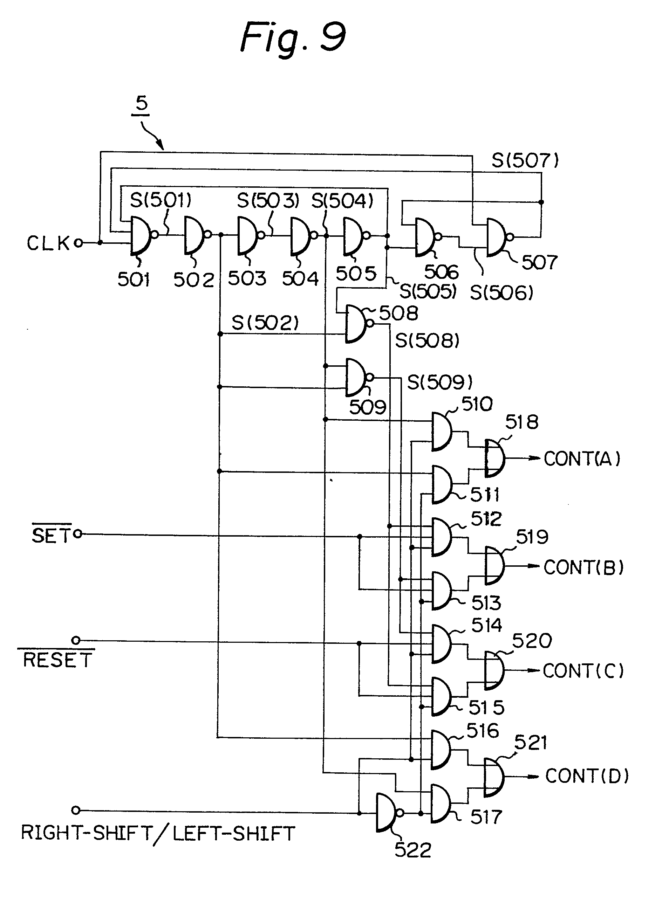

An example of the control clock signal generation circuit is shown in Fig. 9.  The control clock signal generation circuit 5 shown in Fig. 9 provides a 3-input NAND gate 501, inverters 502, 503, 504, 505, and 522, 2-input NAND gates 506, 507, 508, and 509, 2-input AND gates 510, 511, 512, 513, 514, 515, 516, and 517, and 2-input OR gates 518, 519, 520, and 521.

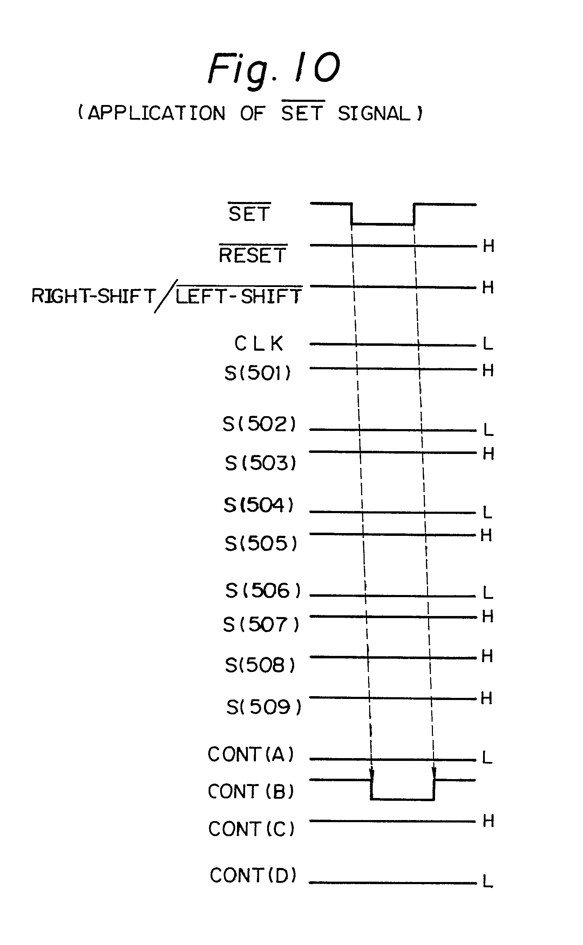

The operation of the control clock signal generation circuit 5 shown in Fig. 9 will be described with reference to the waveforms shown in Figs. 10 to 13.

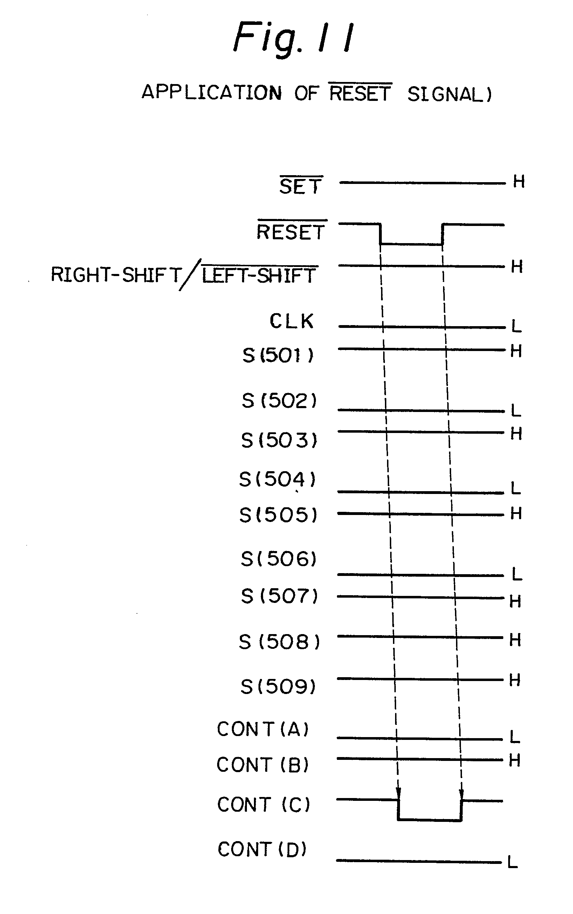

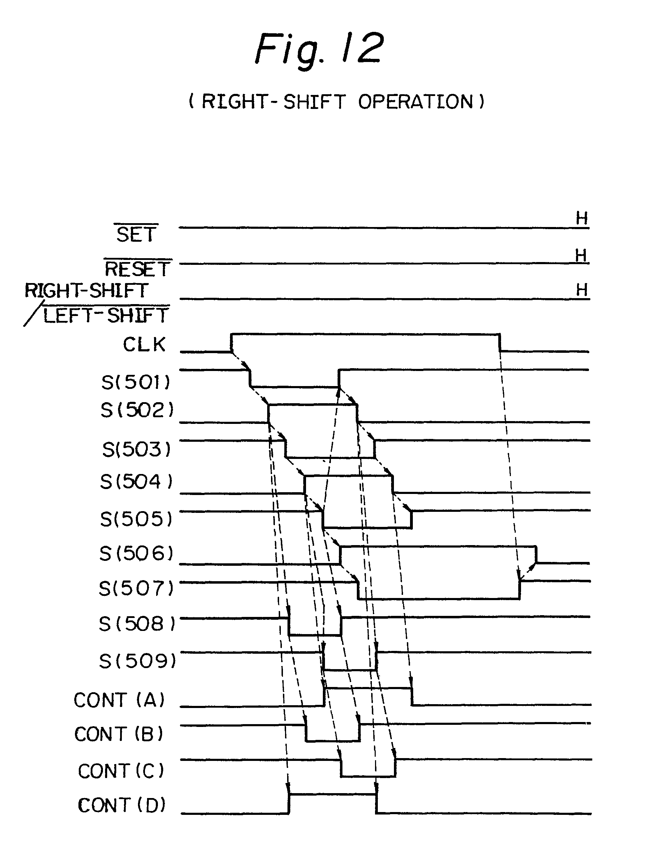

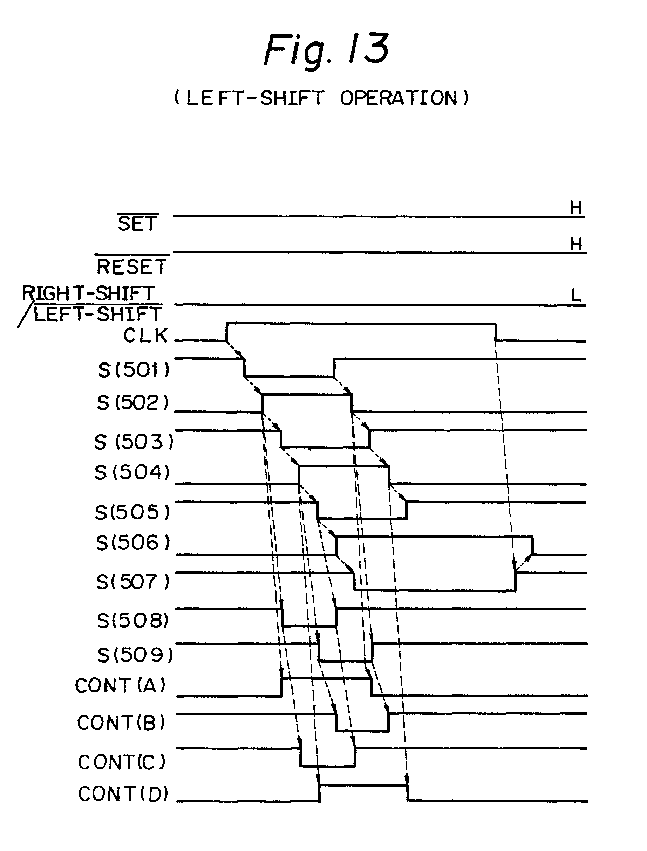

The case in which the $\overline{SET}$ (barred SET) signal is applied to the control clock signal generation circuit is illustrated in Fig. 10.  As shown in Fig. 10, since the potential of the clock signal CLK is LOW, the potentials of the signals S(508) and S(509) are HIGH. Since the potential of the right-shift/left-shift signal is HIGH, the potential of the control signal CONT(B) becomes LOW, through the AND gate 512 and the OR gate 519, corresponding to the period of the LOW potential of the $\overline{SET}$ signal.  The CONT(A), CONT(B), CONT(C), and CONT(D) correspond to the above described control clock signals CONT(A), CONT(B), CONT(C), and CONT(D). The case in which the $\overline{RESET}$ (barred RESET) signal is

- 13 -                     0173570

applied to the control clock signal generation circuit is illustrated in Fig. 11. As shown in Fig. 11, the control signal CONT(C) is delivered through the AND gate 514 and the OR gate 520, during the period of the LOW potential of the $\overline{RESET}$ signal. The case in which the right-shift operation is to be carried out is illustrated in Fig. 12. As shown in Fig. 12, the potential of the right-shift/$\overline{left-shift}$ signal is made HIGH, and the potential of the clock signal CLK is made HIGH during a predetermined period. Accordingly, the signals S(501) through S(509) are changed as illustrated, and the control signals CONT(A), CONT(B), CONT(C), and CONT(D) are delivered as illustrated through AND gates carrying even reference number. The case in which the left-shift operation is to be carried out is illustrated in Fig. 13. As shown in Fig. 13, the potential of the right-shift/$\overline{left-shift}$ signal is made LOW, and the potential of the clock signal CLK is made HIGH during a predetermined period. The signals S(501) through S(509) are changed as illustrated, and the control signals CONT(A), CONT(B), CONT(C), and CONT(D) are delivered as illustrated through the AND gates carrying odd reference numbers.

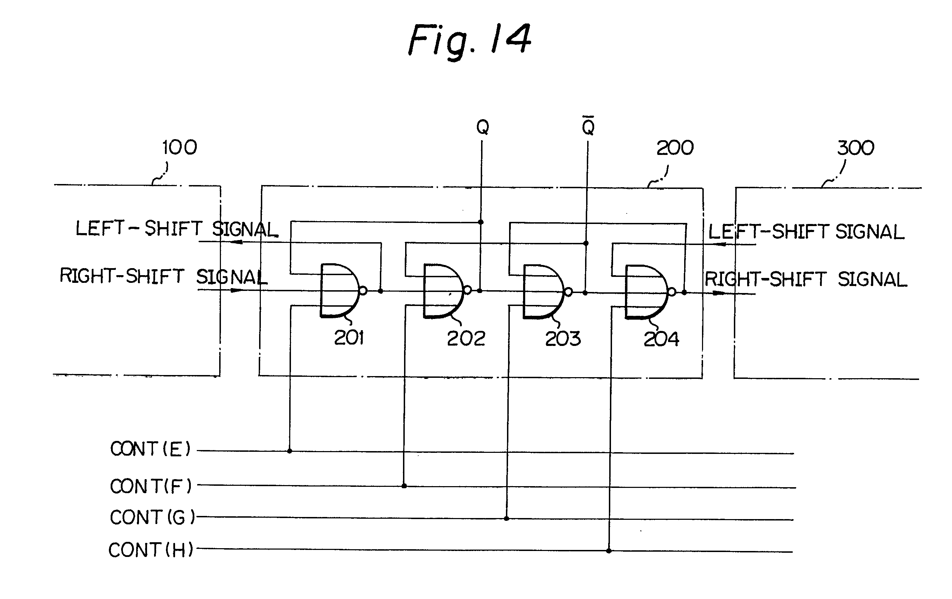

An elementary shift register circuit for a shift register circuit according to another embodiment of the present invention is shown in Fig. 14. In this embodiment, NOR gates are used in place of the NAND gates in the circuit shown in Fig. 2.

The elementary shift register circuit 200 shown in Fig. 14 consists of NOR gates 201, 202, 203, and 204. To each third input terminal of the NOR gates 201 to 204, control signals CONT(E), CONT(F), CONT(G), and CONT(H) are applied. The control signals CONT(E), CONT(F), CONT(G), and CONT(H) are the inverted signals of the control signals CONT(A), CONT(B), CONT(C), and CONT(D), respectively.

It is possible to use a transistor-transistor-logic

- 14 -      0173570

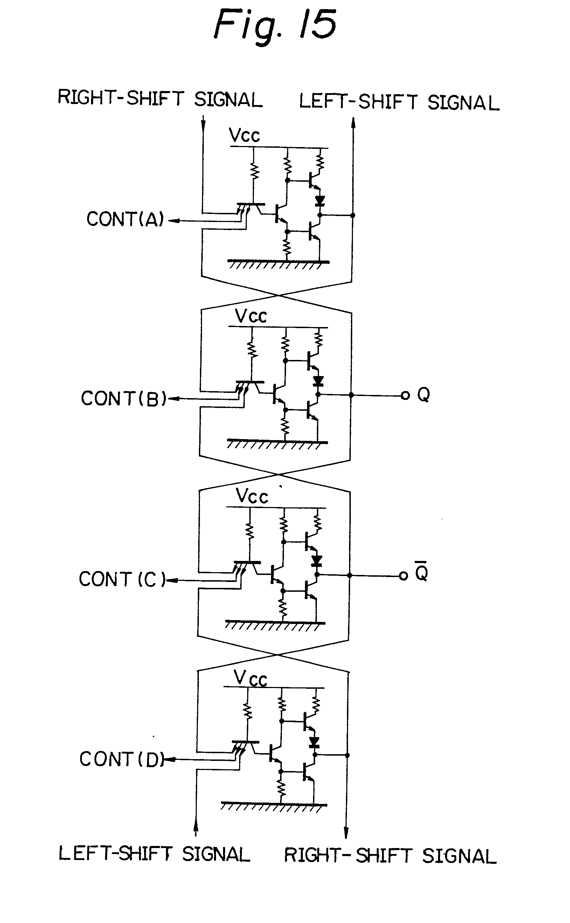

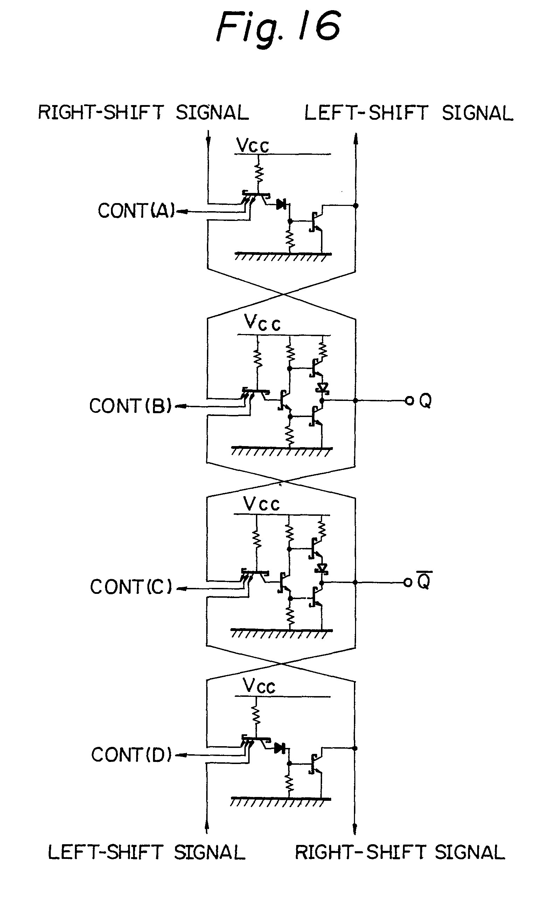

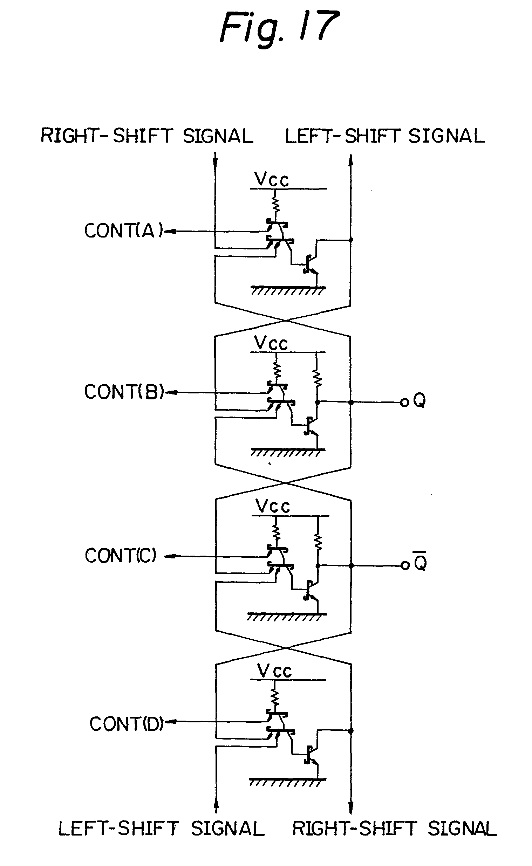

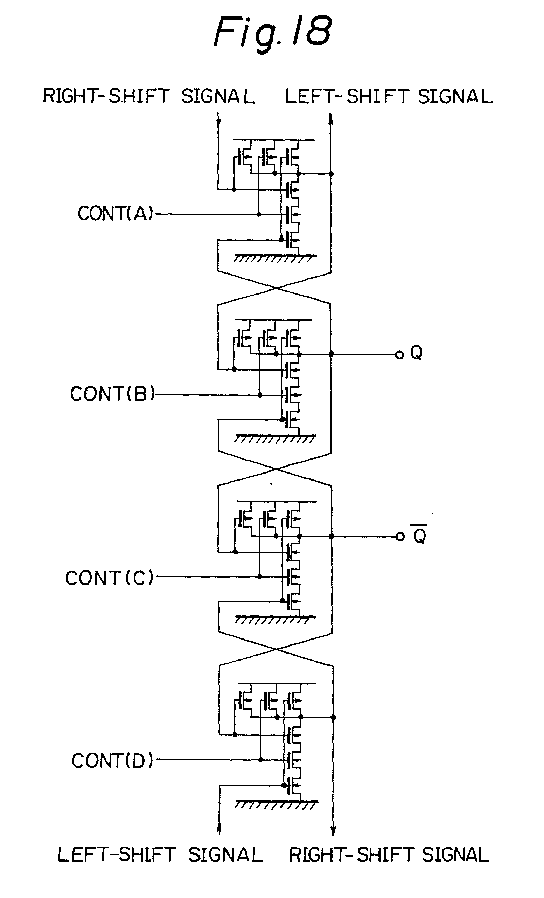

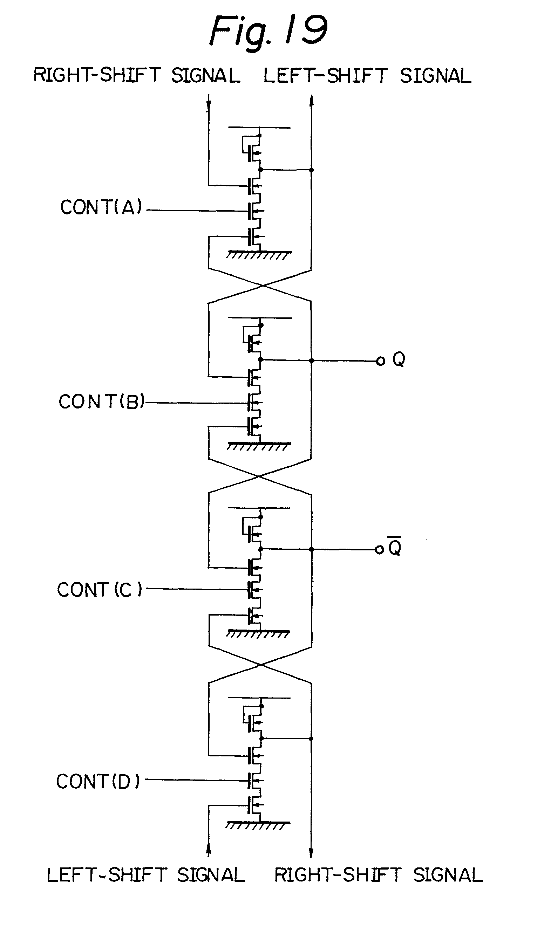

(TTL) circuit, a low power Schottky transistor-transistor-logic (LS-TTL) circuit, a modified low power Schottky transistor-transistor-logic circuit, a complementary metal oxide semiconductor (CMOS) circuit, or a metal oxide semiconductor (MOS) circuit for the NAND gate of the circuit shown in Fig. 2. The transistor-transistor-logic circuit is shown in Figs. 15, 16, and 17, the low power Schottky transistor-transistor-logic circuit in Fig. 16, the modified low power Schottky transistor-transistor-logic circuit in Fig. 17, the complementary metal oxide semiconductor circuit in Fig. 18, and the metal oxide semiconductor circuit in Fig. 19.

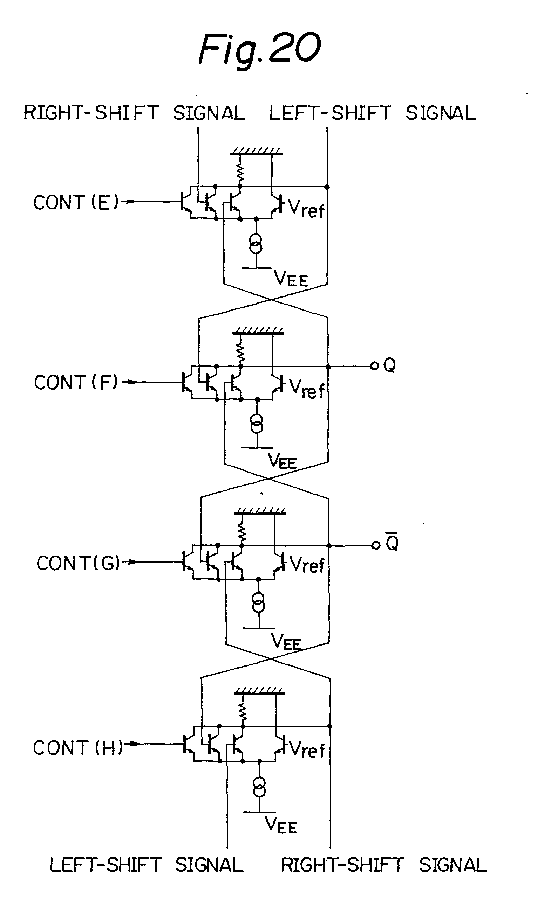

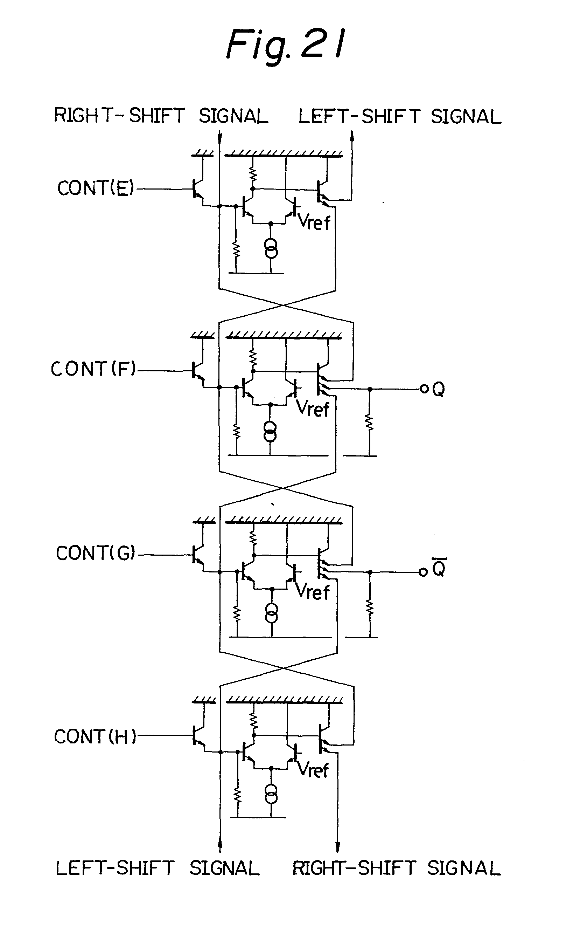

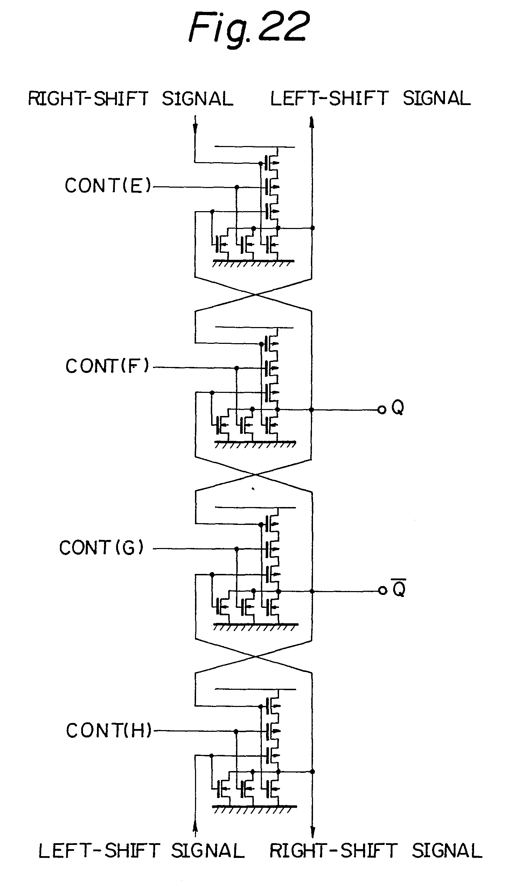

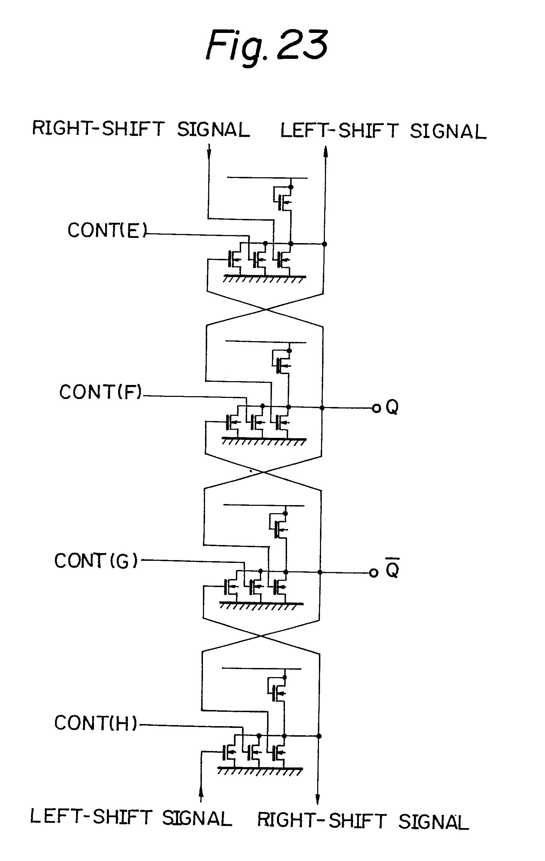

It is possible to use a current mode logic (CML) circuit, a modified current mode logic circuit, a complementary metal oxide semiconductor (CMOS) circuit, or a metal oxide semiconductor (MOS) circuit for the NOR gate of the circuit shown in Fig. 14. The current mode logic circuit is shown in Fig. 20, the modified current mode logic circuit in Fig. 21, the complementary metal oxide semiconductor circuit in Fig. 22, and the metal oxide semiconductor circuit in Fig. 23.

## CLAIMS

1. An elementary circuit (1, 2, 3) for holding one data bit in a shift register circuit comprising four gates (21, 22, 23, 24) connected in sequence, each of the gates (22) having a first input terminal for receiving an output signal of the succeeding gate (23), a second input terminal for receiving an output signal of the preceding gate (21), and a third input terminal for receiving predetermined control signals (CONT A-D), the outputs of second (22) and third (23) gates forming outputs (Q, $\overline{Q}$) of the elementary circuit for one bit of the shift register, and, a first (CONT A), a second (CONT B), a third (CONT C), and a fourth (CONT D) control signal being applied to the third input terminals respectively of the first to fourth gates (21, 22, 23, 24).

2. A shift register circuit wherein a number of elementary shift register circuits according to claim 1 (1, 2, 3),)are connected together in sequence to hold a corresponding number of data bits.

3. A shift register circuit comprising a plurality of elementary shift register circuits (1, 2, 3) connected in sequence, each of the elementary shift register circuits (1, 2, 3) comprising a first (21), a second (22), a third (23), and a fourth (24) logic gate, the output of the second logic gate (22) being connected to a first input terminal of the first logic gate (21), a right-shifted signal from a preceding elementary shift register circuit (1) being supplied to the second input terminal of the first logic gate (21), the output of the third logic gate (23) being connected to a first input terminal of the second logic gate (22), the output of the first logic gate (21) being connected to a second input terminal of the second logic gate (22), the output of the fourth logic (23) gate being connected to a first input terminal of the third logic gate (23), the output of the second logic gate (22) being connected to a second input terminal of the third logic gate (23), a left-shifted signal from a succeeding elementary shift register circuit (3) being supplied to a first input terminal of the fourth logic gate (24), the output of the third logic gate (23) being connected to the second input terminal of the fourth logic gate (24), digital signals having predetermined polarity, predetermined duration, and predetermined timing with respect to a sequential order being supplied to the third input terminals of each of the first to fourth logic gates (21, 22, 23, 24), the output of the first logic gate being supplied to the preceding elementary shift register (1) circuit as a left-shifted signal, the output of the fourth logic gate being supplied to the succeeding elementary shift register circuit (3) as a right-shifted signal, and the output of the second logic gate (22) forming a positive output (Q) and the output of the third logic gate (23) forming a negative output ($\overline{Q}$) of the elementary shift register circuit (2).

4. A shift register circuit according to claim 3, wherein the logic gates are all NAND gates.

5. A shift register circuit according to claim 3, wherein the logic gates are all NOR gates.

6. A shift register circuit according to claim 4, wherein the NAND gates are formed by a transistor-transistor-logic circuits.

7. A shift register circuit according to claim 4 or 5, wherein the logic gates are constituted by complementary MOS circuits.

8. A shift register circuit according to claim 4 or 5, wherein the logic gates are constituted by MOS circuits.

9. A shift register according to claim 5, wherein the NOR gates are constituted by current mode logic circuits.

# Fig. 1

SET

RIGHT-SHIFT SIGNAL
(FROM PRECEDING ELEMENTARY
CIRCUIT)

807

809

804

LEFT-SHIFT SIGNAL
(FROM SUCCEEDING ELEMENTARY
CIRCUIT)

801

806

Q

808

CLK

802

RIGHT-SHIFT / LEFT-SHIFT

810

803

805

Q̄

RESET

8

0173570

Fig. 2

# Fig. 3

# Fig. 4

CHANGES OF CONTROL SIGNAL POTENTIALS
FOR RIGHT-SHIFT OPERATION

| | ELEMENTARY CIRCUIT 1 | | | | ELEMENTARY CIRCUIT 2 | | | | ELEMENTARY CIRCUIT 3 | | | |
|---|---|---|---|---|---|---|---|---|---|---|---|---|
| | GATE 11 | GATE 12 | GATE 13 | GATE 14 | GATE 21 | GATE 22 | GATE 23 | GATE 24 | GATE 31 | GATE 32 | GATE 33 | GATE 34 |
| 1 | L | [H | H] | L | L | [H | H] | L | L | [H | H] | L |
| 2 | L | H | H | H | L | H | H | H | L | H | H | H |
| 3 | L | L | [H | H] | L | L | [H | H] | L | L | [H | H] |
| 4 | H | L | H | H | H | L | H | H | H | L | H | H |
| 5 | [H] | L | L | [H | H] | L | L | [H | H] | L | L | [H] |
| 6 | H | H | L | H | H | H | L | H | H | H | L | H |
| 7 | [H | H] | L | L | [H | H] | L | L | [H | H] | L | L |
| 8 | H | H | H | L | H | H | H | L | H | H | H | L |
| 1 | L | [H | H] | L | L | [H | H] | L | L | [H | H] | L |

4/21

0173570

# *Fig. 5* (RIGHT-SHIFT OPERATION)

CONT (A)

CONT (B)

CONT (C)

CONT (D)

LEFT-SHIFT SIGNAL $\qquad$ H/L $(\overline{Q}_n)$

Q $\qquad$ H/L $(Q_{n-1})$ $\qquad$ H/L $(Q_n)$

$\overline{Q}$ $\qquad$ H/L $(\overline{Q}_{n-1})$ $\qquad$ H/L $(\overline{Q}_n)$

RIGHT-SHIFT SIGNAL $\qquad$ H/L $(Q_{n-1})$

$t_a$

# *Fig. 6* (LEFT-SHIFT OPERATION)

CONT (A)

CONT (B)

CONT (C)

CONT (D)

LEFT-SHIFT SIGNAL $\qquad$ H/L $(\overline{Q}_{n-1})$

Q $\qquad$ H/L $(Q_{n-1})$ $\qquad$ H/L $(Q_n)$

$\overline{Q}$ $\qquad$ H/L $(\overline{Q}_{n-1})$ $\qquad$ H/L $(\overline{Q}_n)$

RIGHT-SHIFT SIGNAL $\qquad$ H/L $(Q_n)$

$t_a$

# Fig.7 (APPLICATION OF SET SIGNAL)

CONT(A) ──────────────────────────── L

CONT(B) ────┐    ┌──────────── 

CONT(C) ──────────────────────────── H

CONT(D) ──────────────────────────── L

LEFT-SHIFT SIGNAL ───────────────── H

Q        H/L

Q̄        H/L

RIGHT-SHIFT SIGNAL ──────────────

|← →|
$t_a$

# Fig. 8 (APPLICATION OF RESET SIGNAL)

CONT(A) ──────────────────────────── L

CONT(B) ──────────────────────────── H

CONT(C) ────┐    ┌────────────

CONT(D) ──────────────────────────── L

LEFT-SHIFT SIGNAL ───────────────── H

Q        H/L

Q̄        H/L

RIGHT-SHIFT SIGNAL ──────────────── H

|← →|
$t_a$

Fig. 9

# Fig. 10

(APPLICATION OF $\overline{SET}$ SIGNAL)

# Fig. 11

APPLICATION OF $\overline{\text{RESET}}$ SIGNAL)

| | |
|---|---|
| $\overline{\text{SET}}$ | H |
| $\overline{\text{RESET}}$ | |
| RIGHT-SHIFT/$\overline{\text{LEFT-SHIFT}}$ | H |
| CLK | L |
| S(501) | H |
| S(502) | L |
| S(503) | H |
| S(504) | L |
| S(505) | H |
| S(506) | L |
| S(507) | H |
| S(508) | H |
| S(509) | H |
| CONT(A) | L |
| CONT(B) | H |
| CONT(C) | |
| CONT(D) | L |

# Fig. 12

(RIGHT-SHIFT OPERATION)

　　　　　　0173570

# Fig. 13

## (LEFT-SHIFT OPERATION)

Fig. 14

## Fig. 15

RIGHT-SHIFT SIGNAL    LEFT-SHIFT SIGNAL

CONT(A)

Vcc

CONT(B)    Q

Vcc

CONT (C )    $\overline{Q}$

Vcc

CONT(D)

Vcc

LEFT-SHIFT SIGNAL    RIGHT-SHIFT SIGNAL

## Fig. 16

## Fig. 17

16/21

0173570

# Fig.18

RIGHT-SHIFT SIGNAL    LEFT-SHIFT SIGNAL

CONT(A)

CONT(B)                                    o Q

CONT(C)                                    o $\overline{Q}$

CONT(D)

LEFT-SHIFT SIGNAL    RIGHT-SHIFT SIGNAL

0173570

# Fig. 19

RIGHT-SHIFT SIGNAL    LEFT-SHIFT SIGNAL

CONT(A)

CONT(B) ————————————————————o Q

CONT(C) ————————————————————o $\overline{Q}$

CONT(D)

LEFT-SHIFT SIGNAL    RIGHT-SHIFT SIGNAL

0173570

# Fig.20

RIGHT-SHIFT SIGNAL    LEFT-SHIFT SIGNAL

CONT (E) →    $V_{ref}$    $V_{EE}$

CONT (F) →    $V_{ref}$    o Q    $V_{EE}$

CONT(G) →    $V_{ref}$    o $\bar{Q}$    $V_{EE}$

CONT (H) →    $V_{ref}$    $V_{EE}$

LEFT-SHIFT SIGNAL    RIGHT-SHIFT SIGNAL

# Fig. 21

RIGHT-SHIFT SIGNAL    LEFT-SHIFT SIGNAL

CONT(E)

$V_{ref}$

CONT(F)

$V_{ref}$

○ Q

CONT(G)

$V_{ref}$

○ $\overline{Q}$

CONT(H)

$V_{ref}$

LEFT-SHIFT SIGNAL    RIGHT-SHIFT SIGNAL

## Fig.22

RIGHT-SHIFT SIGNAL    LEFT-SHIFT SIGNAL

CONT(E)

CONT(F)                                    o Q

CONT(G)                                    o $\overline{Q}$

CONT(H)

LEFT-SHIFT SIGNAL    RIGHT-SHIFT SIGNAL

## Fig. 23

RIGHT-SHIFT SIGNAL    LEFT-SHIFT SIGNAL

CONT(E)

CONT(F)                                    ○ Q

CONT(G)                                    ○ Q̄

CONT(H)

LEFT-SHIFT SIGNAL    RIGHT-SHIFT SIGNAL